# FASCICULE DE BREVET EUROPEEN

(11) **EP 2 852 981 B1**
(45) Date de publication et mention de la délivrance du brevet: **02.05.2018**
(21) Numéro de dépôt: 13723162.7
(22) Date de dépôt: 17.05.2013
(51) Int. Cl.: H01L 31/0224, H01L 31/05

(54) **MODULE PHOTOVOLTAÏQUE AVEC CELLULES PHOTOVOLTAÏQUES À ÉLARGISSEMENT LOCAL DU BUS**
PHOTOVOLTAIKMODUL MIT PHOTOVOLTAISCHEN ZELLEN MIT LOKALER SCHIENENAUSBREITUNG
PHOTOVOLTAIC MODULE WITH PHOTOVOLTAIC CELLS HAVING LOCAL WIDENING OF THE BUS

(30) Priorité: 21.05.2012 FR 1254609
(43) Date de publication de la demande: 01.04.2015
(73) Titulaire: Commissariat à l'Énergie Atomique et aux Énergies Alternatives, 75015 Paris (FR)
(72) Inventeur: BETTINELLI, Armand, 38500 Coublevie (FR)
(74) Mandataire: Novaimo
(86) Numéro de dépôt international: PCT/EP2013/060219
(87) Numéro de publication internationale: WO 2013/174734

(56) Documents cités:
- WO-A2-2012/028537
- JP-A- 2009 272 405
- KR-A- 20110 018 659
- US-A1- 2012 042 925

## Description

### Domaine technique de l'invention

L'invention concerne un module photovoltaïque comprenant plusieurs cellules photovoltaïques électriquement connectées entre elles par l'intermédiaire d'au moins un ruban métallique interconnecté à au moins un bus des cellules photovoltaïques.

L'invention a pour objet également un procédé de fabrication d'un tel module photovoltaïque.

### État de la technique

L'amélioration des performances des cellules photovoltaïques fait l'objet de recherche permanente. L'un des objectifs est d'augmenter le rendement de conversion lumière reçue/électricité fournie, tout en contenant autant que possible le coût de conversion afin d'obtenir le meilleur ratio possible entre l'énergie disponible et le coût d'obtention. L'amélioration de ce ratio peut être obtenue par une augmentation des performances des cellules photovoltaïques et/ou par une réduction de leur coût.

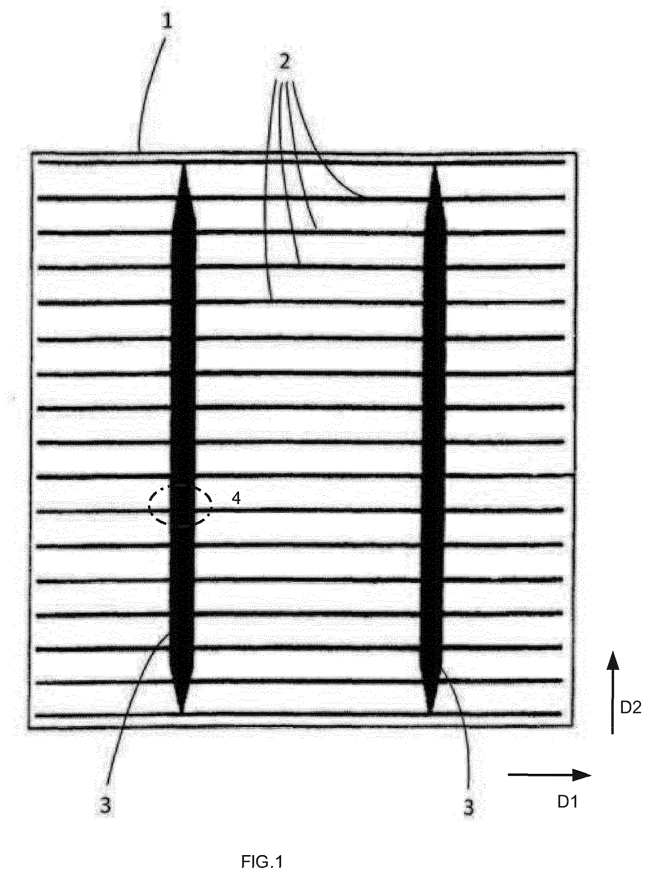

Une cellule photovoltaïque est classiquement fabriquée à l'aide d'un substrat en matériau semi-conducteur, généralement en silicium, connu sous sa dénomination anglaise de « wafer ». Cette fabrication nécessite en particulier la formation de conducteurs électriques sur la surface de ce substrat. La figure 1 illustre la face avant d'un tel substrat 1 selon l'état de la technique, qui comprend des premiers conducteurs parallèles orientés selon une première direction d'allongement D1 et ayant chacun une largeur relativement fine comptée perpendiculairement à leur direction d'allongement D1. Ils sont appelés « doigts de collecte » ou « peignes de collecte », sont repérés 2 et leur fonction est de collecter les électrons créés par la lumière dans le silicium du substrat 1. La face avant du substrat 1 comprend de plus des deuxièmes conducteurs parallèles orientés selon une deuxième direction d'allongement D2. Ils sont connus sous la dénomination « bus » ou « bus barre » et sont repérés par la référence 3. La fonction d'un bus 3 est de récupérer et de conduire les charges électriques issues des doigts de collecte 2 avec lesquels il est en contact électrique au niveau de zones de liaisons électriques 4. Plus généralement, un bus 3 donné est associé à une pluralité de doigts de collecte 2 au niveau de zones de liaisons électriques 4 correspondantes échelonnées sur la longueur du bus 3, les charges électriques conduites par le bus 3 sont donc plus élevées que celles conduites par chaque doigt de collecte 2. Le bus 3 présente une largeur comptée perpendiculairement à sa direction d'allongement D2 nettement supérieure à la largeur des doigts de collecte 2. Les bus 3 sont notamment orientés dans une direction d'allongement D2 perpendiculaire à la direction d'allongement D1 des doigts de collecte 2.

En général, chaque bus 3 est en outre interconnecté électriquement et mécaniquement à un ruban métallique 5, notamment en cuivre, s'étendant sur tout ou partie de sa longueur. Pour réaliser une telle interconnexion continue ou éventuellement discontinue sur la longueur du bus 3, le ruban métallique 5 peut être connecté au bus 3 par un moyen de fixation 6 électriquement conducteur de type soudure ou adhésif conducteur (colle conductrice ou film adhésif conducteur), sur tout ou partie de la longueur du bus 3 selon la direction D2. Le ruban métallique 5 s'étend donc aussi selon D2 et recouvre théoriquement le bus 3 dans toute sa largeur suivant D1. Un ruban métallique 5 est destiné à relier électriquement une pluralité de cellules photovoltaïques entre elles. Un module photovoltaïque se compose donc classiquement d'une pluralité de cellules photovoltaïques et d'au moins un ruban métallique 5 interconnecté à au moins un bus de ces cellules de sorte à relier électriquement les cellules entre elles.

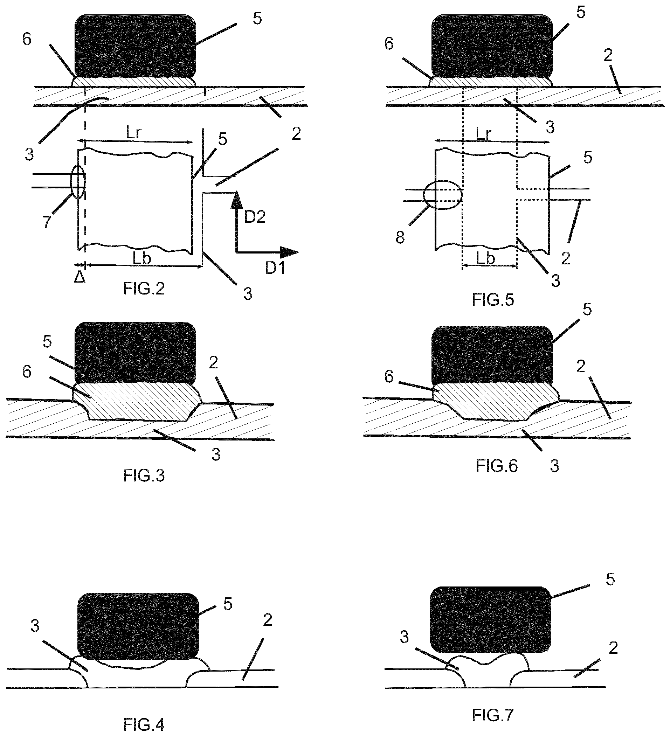

Pour réaliser ces conducteurs (doigts de collecte 2 et bus 3), une méthode connue de l'état de la technique, dite « Simple Print », consiste à déposer une encre conductrice par sérigraphie sur le substrat 1, avec une impression sérigraphique durant laquelle les bus 3 sont conjointement formés avec les doigts de collecte 2. Généralement, la largeur Lb des bus 3 est équivalente à la largeur Lr des rubans métalliques 5 pour ne pas engendrer un ombrage supplémentaire concernant la lumière reçue par la face avant du substrat 1. Toutefois, comme l'illustre la figure 2, l'alignement des rubans métalliques 5 par rapport aux bus 3 et aux doigts de collecte 2 est susceptible d'être imparfait en pratique, dans le plan des directions D1 et D2. L'un des bords du ruban métallique 5 peut notamment présenter un décalage Δ selon la direction D1 par rapport au bus 3 auquel il est interconnecté, de sorte que ce bord de ruban métallique 5 est situé à la verticale (considérée dans la direction perpendiculaire au plan de la face avant du substrat 1, donc perpendiculairement aux directions D1 et D2) d'une partie 7 des doigts de collecte 2. Ces parties 7 de doigts de collecte 2 sont soumises à des contraintes lors de l'étape d'interconnexion entre le bus et le ruban, par exemple avec un risque de dissolution partielle par l'opération de soudure du ruban 5 ou avec l'existence d'une forte pression en cas d'interconnexion au moyen d'un film adhésif conducteur. Des bavures qui peuvent être présentes dans les angles des rubans métalliques 5 de section rectangulaire peuvent accentuer les contraintes exercées sur les doigts de collecte 2.

Les parties 7 des doigts de collecte 2 sont aussi soumises à des contraintes durant la vie du module photovoltaïque. Par exemple, les variations de température ont pour effet de créer des contraintes dues aux différences de dilatation entre la cellule photovoltaïque et les rubans métalliques 5 interconnectés. Ainsi, la multiplication de cycles thermiques peut engendrer des dégradations de performances des modules, notamment sous forme de discontinuités se produisant sur les doigts de collecte 2 au droit du bord des rubans métalliques en cas de décalage Δ par rapport au bus 3. La probabilité que ce phénomène se produise est d'autant plus grande que les doigts de collecte 2 présentent une largeur faible, que les rubans 5 comportent des bavures, que les rubans 5 présentent une épaisseur élevée. L'utilisation de pâtes à basse température pour la fabrication de cellules photovoltaïques à hétérojonction et l'absence de cuisson à haute température induite par de telles pâtes, rendant les doigts de collecte 2 encore plus fragiles et augmentent la probabilité de dégradation dans le temps.

Or, une évolution de l'état de la technique consiste justement à réaliser des métallisations correspondant aux doigts de collecte 2 les plus étroites possibles. Une diminution de la largeur des doigts de collecte 2 permet d'augmenter le courant produit par la cellule photovoltaïque via une réduction de l'ombrage formé pour la lumière vis-à-vis du substrat 1. Cela permet également une réduction avantageuse de la consommation de matériau pour la formation des doigts de collecte 2, ce qui est important dans le contexte actuel à propos du prix croissant des matières premières telles que l'argent par exemple. Toutefois, les doigts de collecte 2 doivent être suffisamment épais pour leur éviter une trop forte résistivité. Avec un procédé « Simple Print », une telle contrainte se traduit par l'impression de bus 3 également plus épais. La consommation de matière est donc très élevée.

C'est pourquoi, une autre méthode connue de l'état de la technique consiste à ce que les éléments conducteurs formés par les doigts de collecte 2 et par les bus 3 soient imprimés en deux temps.

Une première technique en référence à la figure 3, dite « Double Print », consiste en deux impressions superposées des doigts de collecte 2, les bus 3 étant imprimés uniquement durant l'une de ces deux impressions pour limiter la consommation de matière. La technologie « Double Print » permet avantageusement d'obtenir le ratio entre la largeur et la hauteur des doigts de collecte 2 le plus élevé mais elle nécessite un alignement parfait des deux niveaux d'impressions superposés.

Une deuxième technique en référence à la figure 4, dite « Dual Print », consiste en une impression de l'intégralité des doigts de collecte seuls dans un premier temps, suivie d'une autre impression des bus 3 seuls dans un deuxième temps. La technologie « Dual Print » permet avantageusement de limiter les contraintes rhéologiques d'impression étroite pour les bus 3 et ainsi d'utiliser des pâtes moins coûteuses uniquement optimisées en termes d'adhérence et de soudabilité, ces pâtes étant déposées en épaisseur minimale. Les contraintes de résistance sont faibles puisque les rubans métalliques 5 sont interconnectés. La précision requise au sujet de l'alignement entre les deux impressions est également nettement inférieure.

Avec les technologies « Double Print » et « Dual Print », comme l'illustrent les figures 3 et 4, il apparaît des problématiques d'irrégularité de l'épaisseur des métallisations (doigts de collecte 2 et/ou bus 3) dans la zone d'interconnexion entre les bus 3 et les rubans métalliques 5. Or, la qualité et la fiabilité de l'interconnexion entre le ruban métallique 5 et les métallisations peuvent être affectées par ces irrégularités d'épaisseur, avec une répartition irrégulière des contraintes après fixation du ruban métallique 5 par soudure ou collage.

Spécifiquement pour la technologie « Dual Print », la prise de contact entre les doigts de collecte 2 et les bus 3 devient problématique. Ce n'est pas directement le cas si les doigts de collecte 2 sont continus à travers la zone de liaison électrique 4, de part en part de celle-ci suivant la première direction D1, ou s'ils dépassent suffisamment sous une zone de reprise du bus 3. Mais dans ces deux cas, la prise de contact induit une irrégularité d'épaisseur particulièrement désavantageuse pour l'interconnexion du ruban métallique 5. Il reste possible de s'affranchir de telles irrégularités d'épaisseur en déportant la zone de contact entre le bus et le doigt de collecte en dehors de la zone d'interconnexion entre le bus et le ruban métallique. Mais, la précision de l'alignement des deux impressions devient alors un paramètre essentiel.

Pour des questions d'économie de matière, une technique envisagée en référence à la figure 5 consiste enfin à prévoir que la largeur du bus 3 soit nettement inférieure à la largeur du ruban métallique 5 destiné à être interconnecté. Une telle technique est particulièrement avantageuse pour la fabrication de cellules photovoltaïques à hétérojonctions où des pâtes de matière doivent être déposées en forte épaisseur du fait de la résistivité plus élevée des pâtes à basse température. En cas d'interconnexion entre le ruban et le bus par soudure, la surface des bus 3 doit rester suffisamment importante pour avoir une tenue mécanique des rubans soudés. En cas d'interconnexion entre le ruban et le bus par collage, la surface des bus 3 peut être plus fortement réduite, en prenant uniquement garde d'obtenir les résistances de contact souhaitées. Les contraintes de la tenue mécanique sont en effet peu impactées puisque le collage a également lieu sur les zones non conductrices. L'utilisation de bus 3 plus étroits que les rubans 5 implique que les contraintes sur les doigts de collecte 2 à la verticale des bords des rubans 5 sont alors systématiques et élevées dans les zones repérées 8. Les figures 6 et 7 illustrent des problématiques identiques dans le cas respectivement de technologie d'impression « Double Print » et « Dual Print », notamment encore avec l'apparition encore d'irrégularités d'épaisseur. Or, de telles irrégularités de planéité des métallisations sont particulièrement désavantageuses vis-à-vis de la fiabilité de l'interconnexion, lorsque la largeur du bus 3 est faible.

Les documents JP2009272405 et KR20110018659 prévoient des élargissements locaux du bus au niveau de chaque doigt de collecte mais ne décrivent pas de liaison entre différentes cellules.

### Objet de l'invention

Ainsi, un objet général de l'invention est de proposer un module photovoltaïque et un procédé de fabrication qui répondent aux problématiques mentionnés ci-dessus tout en répondant aux problématiques générales de coût et de performance.

Plus précisément, un objet de l'invention est de fournir une solution permettant d'améliorer la fiabilité de la cellule photovoltaïque et/ou du module photovoltaïque indépendamment de la largeur des doigts de collecte et/ou des bus.

Un objet de l'invention est de proposer une solution permettant de limiter les contraintes mécaniques subies par les doigts de collecte.

Un objet de l'invention est de proposer une solution permettant de fiabiliser l'interconnexion mécanique et électrique entre les bus et les rubans métalliques.

Un objet de l'invention est de faciliter la fabrication du module photovoltaïque, notamment l'interconnexion entre les bus et les rubans métalliques.

Ces objets sont atteints par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 illustre schématiquement les doigts de collecte et les bus à la surface d'une cellule photovoltaïque selon l'état de la technique,
- les figures 2 et 5 représentent deux exemples d'application connus de la technologie « Simple Print »,
- les figures 3 et 6 représentent deux exemples d'application connus de la technologie « Double Print »,
- les figures 4 et 7 représentent deux exemples d'application connus de la technologie « Dual Print »,
- la figure 8 représente un premier exemple qui ne fait pas partie de l'invention, utilisant la technologie « Simple Print »,
- la figure 9 représente un deuxième mode de réalisation de l'invention, utilisant la technologie « Double Print »,
- les figures 10 et 11 représentent un troisième exemple ne faisant pas partie de l'invention, et un quatrième mode de réalisation de l'invention, utilisant la technologie « Dual Print »,
- la figure 12 schématise la zone de liaison électrique entre le bus et le doigt de collecte dans le premier mode de réalisation,
- et la figure 13 schématise la zone de liaison électrique entre le bus et le doigt de collecte dans les deuxième, troisième et quatrième modes de réalisation.

### Description de modes préférentiels de l'invention

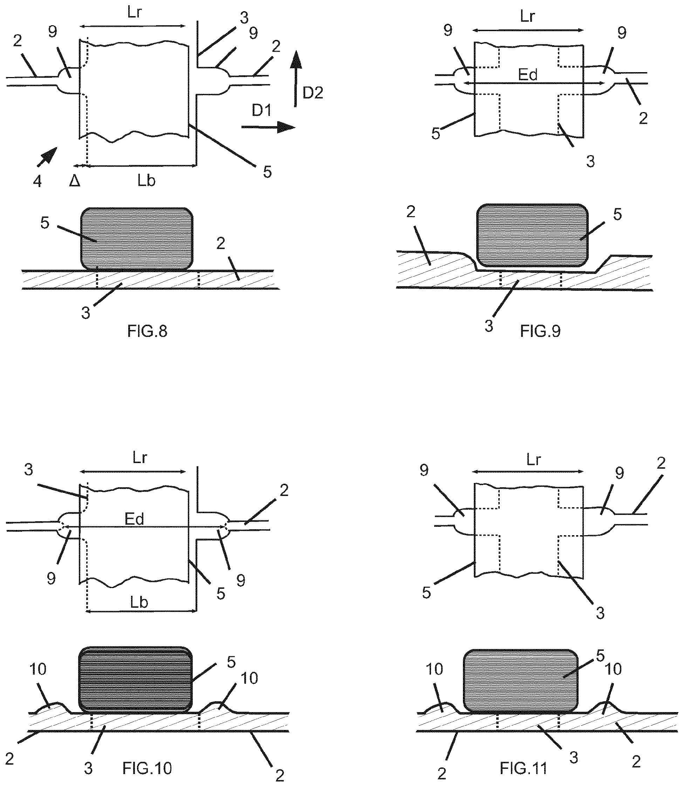

Une cellule photovoltaïque en référence aux figures 8 à 13 comprend des métallisations électriquement conductrices, par exemple formées à base d'argent, sur une face avant du substrat 1 en matériau semi-conducteur, généralement en silicium, connu sous sa dénomination anglaise de « wafer ». Les métallisations pourraient aussi être formées à base de cuivre et notamment à base de cuivre enrobé d'argent. Les références définies lors de la description des figures 1 à 7 sont conservées pour les éléments identiques. Des doigts de collecte 2, en particulier des doigts de collecte 2 continus, sont formés parallèlement entre eux, selon la première direction d'allongement D1. Leur largeur « Wd » est considérée perpendiculairement à leur direction d'allongement D1 et leur largeur « Wd » est, en particulier, sensiblement constante le long de la première direction d'allongement D1. Leur fonction est de collecter les électrons créés par la lumière dans le silicium du substrat 1.

La face avant du substrat 1 comprend aussi au moins un bus 3, voire une pluralité de tels bus 3 parallèles entre eux, chacun étant orienté selon la deuxième direction d'allongement D2. Les bus 3 sont, plus particulièrement, chacun continus. La fonction d'un bus 3 est de récupérer et de conduire les charges électriques issues des doigts de collecte 2. Chaque doigt de collecte 2 est donc connecté à un bus 3 au niveau d'une zone de liaison électrique 4 bus/doigt de collecte. Plus généralement, un bus 3 donné étant associé à une pluralité de doigts de collecte 2 au niveau de différentes zones de liaisons électriques 4 échelonnées sur la longueur du bus 3 selon D2, les charges électriques conduites par le bus 3 sont plus élevées que celles conduites par chaque doigt de collecte 2. Le bus 3 présente donc une largeur « Lb » considérée perpendiculairement à sa direction d'allongement D2 nettement supérieure à la largeur « Wd » des doigts de collecte 2. Les bus 3 sont notamment orientés dans une direction d'allongement D2 formant un angle, notamment à 90°, avec la direction d'allongement D1 des doigts de collecte 2. Dans ce cas particulier, la largeur Wd est comptée suivant la direction D2 et la largeur Lb est comptée suivant la direction D1.

Au niveau de la zone de liaison électrique 4 entre le bus 3 et le doigt de collecte 2, le bus 3 comprend au moins un élargissement local « Le » de la largeur « Lb » du bus 3 suivant la première direction d'allongement D1. Ainsi, la largeur « Lb » d'un bus 3 est, plus particulièrement, considérée comme constante le long de la seconde direction d'allongement D2, à l'exception d'au moins un élargissement local « Le », situé au niveau d'une zone de liaison électrique 4 avec un ou plusieurs doigts de collecte 2. Un élargissement local noté « Le » prend la forme d'une protubérance 9 formée dans le bus 3 dans le plan (D1, D2), suivant la direction D1 pour venir en saillie du bord du bus orienté suivant D2. Par ailleurs, l'élargissement local « Le » du bus 3 présente une longueur (We) selon la deuxième direction d'allongement D2 strictement supérieure à la largeur (Wd) du doigt de collecte 2 correspondant selon la deuxième direction D2.

Dans la variante illustrée, le bus 3 comprend un élargissement « Le » au niveau de sa jonction à chacun des doigts de collecte 2. Il comprend donc deux élargissements formés respectivement sur ses deux bords qui définissent la largeur Lb. Il reste toutefois possible de prévoir que le bus 3 ne comprenne qu'un seul élargissement Le formé en saillie d'uniquement l'un de ses deux bords, notamment dans le cas où un seul doigt de collecte 2 est connecté au bus dans la zone de liaison électrique 4.

Lors de l'interconnexion électrique des cellules photovoltaïques entre elles, en vue de fabriquer un module photovoltaïque muni de plusieurs cellules reliées entre elles, la cellule photovoltaïque reçoit au moins un ruban métallique 5, notamment en cuivre, recouvrant au moins partiellement le bus 3 tout en étant mécaniquement et électriquement connecté au bus 3 par l'intermédiaire d'un moyen de fixation 6 électriquement conducteur de type soudure ou adhésif conducteur, sur tout ou partie de la longueur du bus 3. Le ruban métallique 5 est orienté suivant la deuxième direction D2 sur toute la longueur du substrat 1 et au-delà du substrat 1 pour permettre la connexion électrique de plusieurs cellules photovoltaïques entre elles. Il s'agit de la mise en oeuvre d'une étape d'interconnexion au cours de laquelle le ruban métallique est interconnecté à l'un au moins desdits au moins un bus de la cellule photovoltaïque concernée. Il peut s'agir par exemple d'une étape d'interconnexion par collage et/ou d'une étape d'interconnexion par soudage.

Quel que soit le rapport entre la largeur « Lr » du ruban 5 et la largeur « Lb » du bus, la largeur totale « Lt » du bus 3 au niveau d'un élargissement local du bus 3, c'est-à-dire au niveau de la zone de liaison électrique 4, est plus large que la largeur Lr du ruban métallique 5 suivant la première direction D1. Cette caractéristique présente l'avantage de permettre une meilleure tenue mécanique et électrique du ruban métallique sur la métallisation, c'est-à-dire sur les bus 3 et/ou les doigts de collecte 2, permettant une fiabilisation des interconnexions bus/ruban et une augmentation de la qualité des interconnexions bus/ruban.

Pour apporter une fiabilité maximale en regard des précisons actuelles d'alignement bus/ruban, la différence entre la largeur totale Lt du bus au niveau d'un élargissement local Le et la largeur Lr du ruban métallique, est avantageusement supérieure à 400 microns. Cette différence d'au moins 400 microns peut être répartie de manière égale de part et d'autre du bus 3 suivant la direction D1. Il convient de préciser que la largeur Lr du ruban 5 est considérée perpendiculairement à sa direction d'allongement, qui coïncide ici avec la direction D2.

L'aménagement d'au moins un tel élargissement « Le » sous forme d'une protubérance 9 du bus 3 selon D1 permet avantageusement de :
- fiabiliser l'interconnexion entre le bus 3 et un ruban métallique 5 de largeur « Lr » destiné à être lié mécaniquement et électriquement au bus 3,
- limiter les contraintes subies par les doigts de collecte 2, dans le cas où un décalage Δ est présent entre le ruban 5 et le bus 3 suivant la direction D1 (figures 8 et 10) et/ou dans le cas où la largeur Lr du ruban 5 est volontairement nettement supérieure à la largeur Lb du bus 3 (figures 9 et 11 à 13)
- diminuer la précision éventuellement requise d'alignement dans le cas d'une métallisation réalisée en au moins deux étapes.

Avantageusement, la cellule photovoltaïque comprend une pluralité de doigts de collecte 2 formés sur la face avant du substrat 1. Notamment, plus la largeur Wd des doigts de collecte 2 est faible, plus le nombre de doigts de collecte 2 est élevé. Chaque doigt de collecte 2 est alors relié électriquement à un bus 3 dans une zone de liaison électrique 4 associée de sorte que le bus 3 réalise la connexion électrique des doigts de collecte 2 entre eux suivant la direction D2 entre les zones de liaison électrique 4. De la manière illustrée, chacune des zones de liaison électrique 4 entre le bus 3 et les doigts de collecte 2 comprend un élargissement local de la largeur du bus 3 sous la forme d'une protubérance 9 orientée selon D1 à partir du côté du doigt de collecte 2. Un élargissement donné du bus 3 est associé, d'un côté donné du bus 3 suivant la première direction D1, à un unique doigt de collecte 2. La largeur totale « Lt » du bus 3 au niveau de l'élargissement local de toute zone de liaison électrique 4 est plus large que la largeur Lb du bus 3 hors des zones de liaison électrique 4. Avantageusement, le rapport entre la largeur Lt du bus 3 au niveau d'un élargissement local de sa largeur et la largeur Lb du bus 3 hors des zones de liaison électrique 4, est supérieur à 1,25. Pour apporter une fiabilité maximale en regard des précisons actuelles d'alignement bus/ruban, la différence entre la largeur Lt du bus 3 au niveau d'un élargissement local de sa largeur et la largeur Lb du bus hors des zones de liaison électrique, peut être avantageusement supérieure à 400 microns. Il est possible de prévoir à cet effet que la dimension suivant la direction D1 de chacune des éventuelles deux protubérances 9 de part et d'autre du bus 3 soit supérieure à environ 200 microns, voire 250 microns.

Dans les premier et troisième exemples des figures 8 et 10 respectivement, la largeur Lb du bus 3 est sensiblement égale à la largeur Lr du ruban métallique 5 pour éviter autant que possible un effet d'ombrage du ruban 5 concernant la lumière reçue par la face avant du substrat 1. Toutefois, comme l'illustre la figure 8, l'alignement du ruban métallique 5 par rapport au bus 3 est susceptible d'être imparfait dans la direction D1. L'un des bords du ruban métallique 5 peut notamment présenter un décalage Δ selon la direction D1 par rapport au bus 3 auquel il est interconnecté. Ce bord de ruban métallique 5 est alors avantageusement situé à la verticale (considérée dans la direction perpendiculaire au plan de la face avant du substrat 1, donc perpendiculairement aux directions D1 et D2) d'une protubérance 9 constitutive de l'élargissement local de largeur du bus 3. Ceci permet de s'affranchir de tout risque de connexion directe entre le ruban métallique 5 et les doigts de collecte 2 et de limiter les contraintes subies par les doigts de collecte 2 lors de l'étape d'interconnexion entre le bus 3 et le ruban métallique 5.

Dans les deuxième et quatrième modes de réalisation des figures 9 et 11 respectivement, la largeur Lb du bus 3 en dehors des zones de liaison électrique 4 est nettement inférieure à la largeur du ruban métallique 5. Notamment, le rapport entre la largeur Lr du ruban 5 et la largeur du bus 3 est avantageusement supérieur à deux et de préférence supérieur à 4, ce qui permet de réduire fortement la quantité de métal déposé. Les figures 9 et 11 illustrent que les protubérances 9 présentent une dimension suivant la première direction D1 nettement supérieure que dans le cas des figures 8 et 10 afin de garantir que la largeur totale Lt du bus 3 au niveau de l'élargissement local du bus 3, c'est-à-dire au niveau de la zone de liaison électrique 4, soit malgré tout plus large que la largeur Lr du ruban métallique 5 suivant la première direction D1 en dépit de la faible largeur Lb du bus 3.

Tandis que la dimension comptée selon la direction D1 d'un élargissement local du bus 3 est repérée « Le », la longueur selon la deuxième direction D2 suivant laquelle l'élargissement local « Le » de la largeur du bus 3 est réalisée est repérée « We ». Avantageusement, pour conférer une résistance suffisante au niveau de la jonction entre le doigt de collecte 2 et le bus 3, la longueur We suivant D2 de l'élargissement local du bus 3 est supérieure ou égale à 150 microns, indépendamment de la largeur Wd du doigt de collecte 2. Par ailleurs ou alternativement en fonction du procédé de formation des métallisations, dans le cas d'une largeur Wd du doigt de collecte 2 très faible (par exemple de l'ordre de quelques dixièmes de millimètres), le rapport entre la longueur We et la largeur Wd du doigt de collecte 2 correspondant selon la deuxième direction D2 est supérieur à deux.

De manière générale, la fabrication d'un module photovoltaïque tel que présenté précédemment comprend une étape de métallisation sur un substrat 1 réalisée de sorte à former au moins un doigt de collecte 2 orienté selon D1 et au moins un bus 3 orienté selon D2 qui comprend au moins un élargissement local Le de sa largeur suivant D1, puis une étape d'interconnexion dudit au moins un ruban métallique 5 à au moins un bus 3.

En particulier, pour une cellule photovoltaïque donnée, l'étape de métallisation peut consister en une étape unique dans laquelle ledit au moins un doigt collecte 2 et ledit au moins un bus 3 sont conjointement formés. Alternativement, elle peut aussi être réalisée en plusieurs étapes. En particulier, elle peut être formée par une première étape dans laquelle seul ledit au moins doigt de collecte 2 est réalisé sur le substrat 1 et par une deuxième étape dans laquelle seul ledit au moins un bus 3 est réalisé sur le substrat 1 et à recouvrement d'une partie du doigt de collecte 2 dans la zone de liaison électrique 4. Selon une alternative, l'étape de métallisation peut comprendre une première étape dans laquelle une première couche dudit au moins doigt de collecte 2 est réalisée sur le substrat 1 et une deuxième étape dans laquelle sont conjointement formés :
- ledit au moins un bus 3 sur le substrat 1 et à recouvrement d'une partie de la première couche de doigt de collecte 2 dans la zone de liaison électrique 4,
- une deuxième couche dudit au moins un doigt de collecte 2 sur sa première couche.

Bien que toute technique connue de l'homme du métier puisse être utilisée pour réaliser la métallisation (que ce soit dans le cas d'un procédé de métallisation en une étape unique ou en plusieurs étapes), celle-ci peut être en particulier réalisée par impression d'une encre par sérigraphie sur le substrat 1.

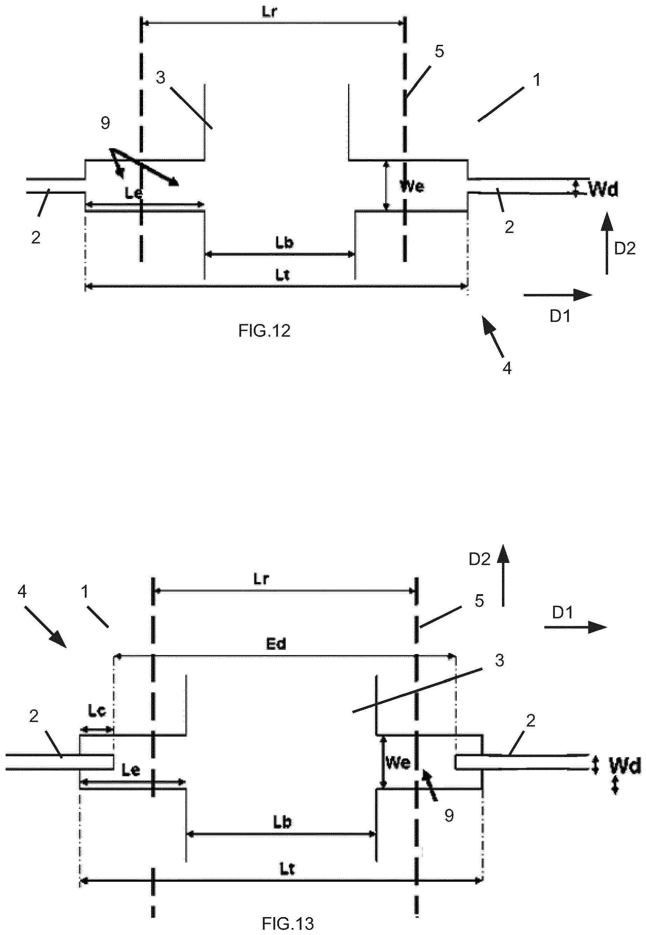

En référence à la figure 12, l'étape de métallisation peut comprendre une étape unique, réalisée en particulier par impression par sérigraphie, dans laquelle le(s) doigt(s) de collecte 2 et le(s) bus 3 sont conjointement formés. Une telle technique dite « Simple Print » est utilisée pour parvenir à l'organisation de la figure 8 par exemple.

Alternativement, l'étape de métallisation peut préférentiellement comprendre, en référence à la figure 13, au moins deux étapes en particulier d'impressions sérigraphiques successives, ce qui permet notamment d'obtenir des largeurs Wd des doigts de collecte 2 inférieures à celles qui peuvent être obtenues par la mise en oeuvre d'une technologie « Simple Print ».

Dans une première solution possible dite « Dual Print », l'étape de métallisation comprend une première étape d'impression sérigraphique dans laquelle seul le(s) doigt(s) de collecte 2 est (sont) réalisé(s) sur le substrat 1 et une deuxième étape d'impression sérigraphique dans laquelle seul le(s) bus 3 est (sont) réalisé(s) sur le substrat 1. Durant la deuxième étape d'impression sérigraphique, le(s) bus 3 vient (viennent) à recouvrement d'une partie du doigt de collecte 2 dans la zone de liaison électrique 4 pour assurer la connexion électrique entre le doigt de collecte 2 et le bus 3. Le recouvrement est prévu au niveau des protubérances 9 formées pour l'élargissement du bus 3 dans la direction D1, ce qui a pour effet de former des bourrelets 10 qui présentent en outre l'avantage de n'avoir aucune incidence sur l'interconnexion ruban/bus car les bourrelets 10 sont déportés de la zone d'interconnexion ruban/bus. Une telle technique « Dual Print » est utilisée pour parvenir à l'organisation des figures 10 et 11.

Notamment, la première étape d'impression peut être réalisée de sorte que le doigt de collecte 2 soit discontinu en aménageant une interruption au niveau de sa zone de liaison électrique 4 au bus 3. Le doigt de collecte présente au moins deux segments alignés selon la première direction D1 avec interposition entre eux d'un espace « Ed » (figures 10 et 13) selon la première direction D1. Avantageusement, les première et deuxième étapes d'impression sérigraphique sont réalisées de sorte que la largeur totale Lt du bus 3 au niveau de l'élargissement local de largeur du bus 3 est supérieure à l'espace Ed entre les deux segments de doigt de collecte 2. Préférentiellement, la différence entre la largeur Lt du bus et l'espace Ed est notamment supérieure à 200 microns et répartie de manière égale de part et d'autre du bus 3 suivant la première direction D1. C'est pourquoi chaque protubérance 9 déborde suivant la première direction D1 le long des segments de doigts de collecte 2 sur une longueur repérée « Lc » supérieure à 100 microns environ. Il reste toutefois envisageable que le doigt de collecte 2 formé durant la première étape d'impression sérigraphique soit continu suivant la direction D1 à travers toute la zone de liaison électrique 4, le bus 3 formé à la deuxième étape étant alors destiné à recouvrir toute cette partie continue de doigt de collecte 2.

Par ailleurs, les première et deuxième étapes d'impression sérigraphique sont réalisées de sorte que la différence entre la largeur Wd du doigt de collecte 2 et la longueur We selon la deuxième direction D2 suivant laquelle l'élargissement local de la largeur du bus 3 est réalisée, est supérieure à 100 microns également. Comme cela est représenté et sans que cela ne soit limitatif, cette différence entre We et Wd peut être répartie, notamment de manière égale, de part et d'autre du doigt de collecte 2 suivant la deuxième direction D2.

Ainsi, via l'absence de métallisation dans l'espace Ed, il est possible de déposer une épaisseur régulière bien contrôlée pour la métallisation des bus 3 au niveau de leur élargissement « Le » du fait d'un bon contact de l'écran utilisé lorsque la sérigraphie du bus est réalisée après la sérigraphie des doigts de collecte 2 seuls, ce qui est important pour minimiser le coût des pâtes de matière, notamment d'argent, utilisées pour les métallisations et participe à la qualité de l'interconnexion entre les rubans 5 et les bus 3.

Dans une deuxième solution possible dite « Double Print », l'étape de métallisation comprend une première étape d'impression sérigraphique dans laquelle une première couche du doigt de collecte 2 est réalisée sur le substrat 1 et une deuxième étape d'impression sérigraphique dans laquelle sont conjointement formés :
- le bus 3 sur le substrat 1 en venant recouvrir une partie de la première couche de doigt de collecte 2 dans la zone de liaison électrique 4,
- une deuxième couche du doigt de collecte 2 sur sa première couche.

Les première et deuxième couches de doigts de collecte 2 sont superposées dans la direction perpendiculaire au plan du substrat 1 et sont en contact électrique l'une avec l'autre. Le recouvrement du bus 3 sur la première couche de doigt de collecte 2 est prévu au niveau des protubérances 9 formées pour l'élargissement du bus 3 dans la direction D1 durant la deuxième étape. Une telle technique « Double Print » est utilisée pour parvenir à l'organisation de la figure 9 par exemple, l'épaisseur des doigts de collecte 2 étant supérieure à celle des bus, la transition entre les deux étant prévues au niveau des protubérances 9 constitutives des élargissements locaux de la largeur du bus 3. Cette technique « Double Print » pourrait indifféremment être réalisée et paramétrée de sorte à parvenir à une largeur Lb du bus 3 sensiblement égale à la largeur du ruban 5 comme dans le cas des figures 8 et 10.

Notamment, la première étape d'impression peut être réalisée de sorte que la première couche de doigt de collecte 2 soit discontinue au niveau de la zone de liaison électrique 4 au bus 3. La première couche de doigt de collecte 2 présente au moins deux segments alignés selon la première direction D1 avec interposition entre eux d'un espace « Ed » (figures 9 et 13) selon la première direction D1. Les première et deuxième étapes d'impression sérigraphique peuvent notamment être réalisées de sorte que la largeur totale Lt du bus 3 au niveau d'un élargissement local soit supérieure à l'espace Ed, cette différence entre la largeur Lt et l'espace Ed étant supérieure à 100 microns et répartie, notamment de manière égale, de part et d'autre du bus 3 suivant la première direction D1. C'est pourquoi chaque protubérance 9 déborde suivant la première direction D1 le long des segments de doigts de collecte 2 sur une longueur repérée « Lc » supérieure à 50 microns environ.

Par ailleurs, dans le cadre d'une technique « Double Print », les première et deuxième étapes d'impression sérigraphique peuvent être réalisées de sorte que le rapport entre la longueur We selon la deuxième direction D2 suivant laquelle l'élargissement local de la largeur du bus 3 est réalisé et la largeur Wd du doigt de collecte 2 correspondant selon la deuxième direction D2, est supérieur à deux.

Parmi les techniques de métallisation susceptibles d'être utilisées dans le cadre de l'invention, on peut citer mis à part l'impression par sérigraphie ; les méthodes sans contact, telles que l'impression par jet d'encre ou par dispense ; technique également connue sous l'acronyme anglo-saxon « dispensing » ; ou par dépôt chimique ou dépôt électrochimique qui permet de déposer des métaux tels que l'argent, le nickel, le cuivre et l'étain.

Il est possible de disposer de zones permettant de manière fiable un contact électrique entre les deux niveaux d'impressions indépendamment du défaut d'alignement entre les deux niveaux d'impression. Le contact électrique fiable est garanti bien que la précision d'alignement des machines de sérigraphie disponibles actuellement soit typiquement de l'ordre de 15 microns.

Durant la fabrication d'un module photovoltaïque comprenant une pluralité de cellules photovoltaïques, il est mis en oeuvre une étape d'interconnexion électrique du ruban métallique 5, notamment en cuivre, au bus 3. Elle est réalisée de sorte que le ruban métallique 5 recouvre au moins partiellement le bus 3 en étant mécaniquement et électriquement connecté à celui-ci par le moyen de fixation 6 électriquement conducteur de type soudure ou adhésif conducteur, sur tout ou partie de la longueur du bus 3. L'étape d'interconnexion et l'étape de métallisation sont préférentiellement réalisées de sorte que l'espace Ed selon la première direction D1 (entre deux segments du doigt de collecte 2 discontinu ou entre deux segments d'une première couche de doigt de collecte 2 discontinu) est supérieur à la largeur Lr du ruban métallique 5 suivant la première direction D1. La différence entre l'espace Ed et la largeur Lr est avantageusement supérieure à 200 microns et répartie, notamment de manière égale, de part et d'autre du bus 3 suivant la première direction D1.

Un module photovoltaïque comprend plusieurs cellules photovoltaïques électriquement connectées entre elles par l'intermédiaire d'au moins un ruban métallique 5 interconnecté à au moins un bus 3 des cellules photovoltaïques.

Les principes décrits ci-dessus sont applicables dans le cadre de cellules photovoltaïques à hétérojonctions ou homojonctions, qu'elles soient mono-faciales ou bifaciales. En particulier, comme la face avant, la face arrière d'une cellule photovoltaïque peut également comprendre des métallisations électriquement conductrices telles qu'exposées ci-dessus. La forme des protubérances 9, bien qu'elles soient représentées de manière rectangulaire dans le plan (D1, D2), peut être quelconque. Notamment, toute forme peut être envisagée permettant une interconnexion sur une zone de dimension supérieure à celles des doigts de collecte 2 pour éviter la rupture de ceux-ci sous contraintes. Cette zone sera toutefois de préférence plane pour permettre une bonne répartition de ces contraintes. De même, les zones de contact entre les deux impressions successives ne sont pas nécessairement de forme rectangulaire et peuvent par exemple adopter une forme de biseau.

Dans un premier exemple ne faisant pas partie de l'invention, la cellule photovoltaïque comprend une métallisation à l'aide d'une encre à base d'argent cuite à haute température (800°C). L'étape d'impression sérigraphique de la face avant du substrat 1 est réalisée en une seule étape sous la technologie « Simple Print » (figure 12). La largeur Wd des doigts de collecte 2 est de 100 µm. La largeur Lb des bus 3 est de 1.5 mm pour assurer l'interconnexion de rubans métalliques 5 de cuivre ayant une largeur Lr de 1.5 mm. Les protubérances 9 sont telles que la longueur We est de 200 µm, la longueur totale Lt est de 1.9 mm. Ainsi l'élargissement Le est de 200 µm de part et d'autre du bus 3. L'interconnexion entre le ruban 5 et le bus 3 se fait par soudure des rubans de cuivre revêtus de 20µm d'un alliage SnPbAg. Les rubans 5 ne recouvrent jamais les doigts de collecte 2 de largeur 100 µm. Ils restent au contraire localisés à la verticale des élargissements 9, même dans le cas d'un défaut d'alignement de 200 microns entre les rubans 5 et les bus 3. Le surcroît d'ombrage lié aux élargissements du bus 3 est quasi nul.

Dans un deuxième exemple ne faisant pas partie de l'invention, la cellule photovoltaïque comprend une métallisation à l'aide d'une encre à base d'argent cuite à haute température (800°C). L'étape d'impression sérigraphique de la face avant du substrat 1 est réalisée en une seule étape sous la technologie « Simple Print » (figure 12). La largeur Wd des doigts de collecte 2 est de 80µm. La largeur Lb des bus 3 est de 0.8 mm pour assurer l'interconnexion de rubans métalliques 5 de cuivre ayant une largeur Lr de 1.5 mm. Les protubérances 9 sont telles que la longueur We est de 200 µm, la longueur totale Lt est de 1.8 mm (correspondant à 500 µm de part et d'autre du bus de 800 µm). L'interconnexion des rubans 5 de cuivre prévoit un rainurage en surface et sont revêtus de 1.3 µm d'argent par collage. L'interconnexion est réalisée via une polymérisation d'un adhésif 6 chargé en particule conductrice à base d'argent. Les rubans 5 de cuivre ne recouvrent jamais les doigts de collecte 2 de largeur 80 µm. Au contraire, ils restent localisés à la verticale des protubérances 9, même dans le cas d'un défaut d'alignement de 150 microns entre les rubans 5 et les bus 3. Le surcroît d'ombrage lié aux élargissements du bus 3 est quasi nul.

Dans un troisième exemple, une cellule photovoltaïque à hétérojonctions réalisée est avec un procédé à basse température. Les métallisations sont formées avec une encre à base d'argent cuite à 200°C. La cellule est bifaciale avec une présence de doigts de collecte 2 sur les deux faces avant et arrière du substrat 1. L'impression sérigraphique de la face avant est de type « Double Print » (figure 13). La largeur Wd des doigts de collecte 2 en face avant est de 90 µm. La première couche de doigts de collecte est discontinue et prévoit un espace Ed de 1.3 mm. La deuxième étape d'impression permet la formation de la deuxième couche des doigts de collecte 2 et des bus avec ses protubérances 9. Le passage de deux épaisseurs à une épaisseur des doigts de collecte 2 se pratique dans les zones correspondant aux élargissements du bus, ce qui évite d'avoir des zones plus résistives. La largeur Lb du bus 3 est de 0.2 mm pour une interconnexion de rubans 5 de cuivre de largeur Lr égale à 1.0 mm. Les protubérances 9 sont telles que la longueur We est 300 µm, la largeur totale Lt égale à 1.6 mm (ainsi, Le est égale à 700 µm de part et d'autre du bus 3). Les zones où les doigts de collecte 2 ont deux couches sont en dehors des zones d'interconnexion où reposent les rubans 5 de cuivre (la zone de longueur « Lc » est placée à l'extérieur de l'espace Ed). Ainsi, les rubans 5 de cuivre reposent sur des zones planes au niveau des élargissements de bus. Ces zones planes permettent au ruban 5 de rester parallèle à la cellule et aux contraintes d'interconnexion de se répartir régulièrement. L'impression sérigraphique de la face arrière est de type « Simple Print » avec une largeur des bus Wd égale à 110 µm. La largeur Lb des bus est de 0.2 mm pour interconnecter des rubans 5 de cuivre ayant une largeur Lr de 1.5 mm. Les protubérances 9 sont configurées de sorte que We est égale à 300 µm, Lt est égale à 1.5 mm (correspondant à 650 µm de part et d'autre du bus 3). L'interconnexion des rubans 5 de cuivre se pratique par collage. Le cuivre est rainuré en surface pour limiter les pertes par réflexion sur les rubans 5 et est revêtu de 1.3 µm d'argent. L'interconnexion est réalisée via une polymérisation d'un adhésif 6 chargé en particule conductrice à base d'argent. Sur les deux faces avant et arrière de la cellule, les rubans 5 de cuivre ne recouvrent jamais les doigts de collecte de largeur Wd égale à 100 µm. Au contraire, ils restent localisés à la verticale des élargissements du bus 3, même dans le cas d'un défaut d'alignement de 150 microns entre les rubans 5 et les bus 3. Le surcroît d'ombrage lié aux élargissements du bus 3 est quasi nul.

Dans un quatrième exemple ne faisant pas partie de l'invention, la cellule photovoltaïque comprend des métallisations réalisées à l'aide d'une encre à base d'argent, cuite à haute température (800°C). L'étape d'impression sérigraphique de la face avant du substrat 1 est réalisée à l'aide de la technologie « Dual Print » (figure 13). La largeur Wd des doigts de collecte 2 en face avant est de 80 µm. La première couche des doigts de collecte 2 discontinus présente un espace Ed égal à 1.7 mm dans les zones destinées à une interconnexion bus/ruban métallique. L'absence de métallisation dans l'espace Ed permet un contact efficace de l'écran lors de l'impression sérigraphique du bus 3, ce qui permet de déposer une épaisseur régulière bien contrôlée. La deuxième étape d'impression sérigraphique prévoit l'impression d'un bus 3 ayant une largeur de 1.4 mm pour assurer une interconnexion d'un ruban 5 de cuivre ayant une largeur de 1.5 mm. La dimension We des élargissements du bus 3 est de l'ordre de 250 µm, et la largeur totale Lt est de l'ordre de 2.1 mm prévoyant une dimension « Le » égale à 350 µm de part et d'autre du bus 3. Le contact entre le doigt de collecte 2 et le bus 3 se fait sur une longueur nominale Lc de égale à 200 µm. L'interconnexion entre le ruban 5 et le bus 3 se pratique par soudure du ruban 5 de cuivre revêtu de 20 µm d'un alliage SnPbAg. Les rubans 5 de cuivre ne recouvrent ainsi jamais les doigts de collecte 2. Au contraire, ils restent localisés à la verticale des élargissements du bus 3 constitués par les protubérances 9 ayant une dimension de 250 µm selon D1, même dans le cas d'un défaut d'alignement de 300 microns entre les rubans 5 et les bus 3. Le surcroît d'ombrage lié aux élargissements du bus 3 est quasi nul.

Enfin, les avantages supplémentaires de la solution précédemment décrite sont essentiellement de permettre de :
- diminuer, voire supprimer, les risques d'interconnexion entre le ruban métallique et les doigts de collecte, que ce soit en cas de décalage involontaire Δ entre le bus et le ruban métallique si la largeur du ruban métallique Lr est sensiblement identique à la largeur Lb du bus 3, ou en cas d'interconnexion d'un ruban métallique présentant volontairement une largeur Lr nettement supérieure à la largeur du bus 3,
- réaliser une interconnexion entre le ruban métallique 5 et le bus 3 sur une surface plane, la métallisation ne présentant pas d'irrégularité d'épaisseur dans la zone d'interconnexion,
- donner des marges avantageuses dans l'alignement des deux impressions dans le cas d'une impression « Dual Print » ou « Double Print ».

## Revendications

1. Module photovoltaïque comprenant plusieurs cellules photovoltaïques chacune comprenant au moins un doigt de collecte (2) orienté dans une première direction d'allongement (D1) et au moins un bus (3) orienté dans une deuxième direction d'allongement (D2) formant un angle avec la première direction d'allongement, notamment un angle de 90 degrés, le bus (3) comprenant, au niveau d'une zone de liaison électrique (4) entre le bus (3) et le doigt de collecte (2), au moins un élargissement local (Le) de la largeur (Lb) du bus (3) suivant la première direction d'allongement (D1), le rapport entre la longueur (We) selon la deuxième direction (D2) suivant laquelle l'élargissement local (Le) de la largeur (Lb) du bus (3) est réalisé et la largeur (Wd) du doigt de collecte (2) correspondant selon la deuxième direction (D2) étant strictement supérieur à un, les cellules photovoltaïques étant électriquement connectées entre elles par l'intermédiaire d'au moins un ruban métallique (5) interconnecté à au moins un bus (3) des cellules photovoltaïques, module **caractérisé en ce que** la largeur totale (Lt) du bus (3) au niveau d'un élargissement local (Le) est strictement supérieure à la largeur (Lr) du ruban métallique (5) suivant la première direction (D1) et **en ce que** la largeur (Lb) du bus (3) en dehors de la zone de liaison électrique est inférieure à la largeur (Lr) du ruban métallique (5), avec un rapport entre la largeur (Lr) du ruban (5) et la largeur (Lb) du bus (3) qui est supérieur à deux, notamment supérieur à quatre.

2. Module photovoltaïque selon la revendication 1, **caractérisé en ce qu'**elle comprend une pluralité de doigts de collecte (2) et **en ce que** chaque doigt de collecte (2) de ladite pluralité est relié électriquement au bus (3) dans une zone de liaison électrique (4) associée, de sorte que le bus (3) réalise la connexion électrique des doigts de collecte (2) entre eux et entre les zones de liaison électrique (4).

3. Module photovoltaïque selon la revendication 2, **caractérisé en ce que** chacune des zones de liaison électrique (4) entre le bus (3) et les doigts de collecte (2) comprend un élargissement local (Le) de la largeur (Lb) du bus (3).

4. Module photovoltaïque selon l'une des revendications 2 et 3, **caractérisé en ce que** la largeur totale (Lt) du bus (3) au niveau de l'élargissement local (Le) de toute zone de liaison électrique (4) est strictement supérieure à la largeur (Lb) du bus (3) hors des zones de liaison électrique (4).

5. Module photovoltaïque selon la revendication 4, **caractérisé en ce que** le rapport entre la largeur (Lt) du bus (3) au niveau d'un élargissement local (Le) de sa largeur et la largeur (Lb) du bus (3) hors des zones de liaison électrique (4), est supérieur à 1,25.

6. Module photovoltaïque selon l'une des revendications 4 et 5, **caractérisé en ce que** la différence entre la largeur (Lt) du bus (3) au niveau d'un élargissement local (Le) de sa largeur et la largeur (Lb) du bus (3) hors des zones de liaison électrique (4), est supérieure à 400 microns.

7. Module photovoltaïque selon l'une des revendications 2 à 6, **caractérisé en ce qu'**un élargissement (Le) donné du bus (3) est associé, d'un côté donné du bus (3) suivant la première direction (D1), à un unique doigt de collecte (2).

8. Module photovoltaïque selon l'une des revendications 1 à 7, **caractérisé en ce que** la longueur (We) selon la deuxième direction (D2) suivant laquelle l'élargissement local (Le) de la largeur (Lb) du bus (3) est réalisé, est supérieure ou égale à 150 microns.

9. Module photovoltaïque selon l'une des revendications 1 à 8, **caractérisé en ce que** le rapport entre la longueur (We) selon la deuxième direction (D2) suivant laquelle l'élargissement local (Le) de la largeur du bus (3) est réalisé et la largeur (Wd) du doigt de collecte (2) correspondant selon la deuxième direction (D2) est supérieur à deux.

10. Module photovoltaïque selon l'une des revendications 1 à 9, **caractérisé en ce que** le ruban métallique (5), notamment en cuivre, est mécaniquement et électriquement connecté à au moins un bus (3) des cellules photovoltaïques, par un moyen de fixation (6) électriquement conducteur de type soudure ou adhésif conducteur, sur tout ou partie de la longueur du bus (3).

11. Module photovoltaïque selon l'une des revendications 1 à 10, **caractérisé en ce que** le ruban métallique (5) est orienté suivant la deuxième direction (D2) sur toute la longueur d'un substrat (1) sur lequel sont formés les doigts de collecte (2) et ledit au moins un bus (3), et au-delà du substrat (1) pour permettre la connexion électrique de plusieurs cellules photovoltaïques entre elles.

12. Module photovoltaïque selon l'une des revendications 1 à 11, **caractérisé en ce que** la différence entre la largeur totale (Lt) du bus (3) au niveau d'un élargissement local (Le) et la largeur (Lr) du ruban métallique (5), est supérieure à 400 microns.

13. Procédé de fabrication d'un module photovoltaïque selon l'une quelconque des revendications 1 à 12 comprenant une étape de métallisation sur un substrat (1), réalisée de sorte à former ledit au moins un doigt de collecte (2) et ledit au moins un bus (3) puis une étape d'interconnexion dudit au moins un ruban métallique (5) à au moins un bus (3) des cellules photovoltaïques.

14. Procédé de fabrication selon la revendication 13, **caractérisé en ce que** l'étape de métallisation consiste en une étape unique dans laquelle ledit au moins un doigt collecte (2) et ledit au moins un bus (3) sont conjointement formés.

15. Procédé de fabrication selon la revendication 13, **caractérisé en ce que** l'étape de métallisation comprend une première étape dans laquelle seul ledit au moins doigt de collecte (2) est réalisé sur le substrat (1) et une deuxième étape dans laquelle seul ledit au moins un bus (3) est réalisé sur le substrat (1) et à recouvrement d'une partie du doigt de collecte (2) dans la zone de liaison électrique (4).

16. Procédé de fabrication selon la revendication 15, **caractérisé en ce que** la première étape est réalisée de sorte que ledit au moins un doigt de collecte (2) est discontinu, interrompu au niveau de sa zone de liaison électrique (4) audit au moins un bus (3), et présente au moins deux segments alignés selon la première direction (D1) avec interposition entre eux d'un espace (Ed) selon la première direction (D1).

17. Procédé de fabrication selon la revendication 16, **caractérisé en ce que** les première et deuxième étapes sont réalisées de sorte que la largeur totale (Lt) du bus (3) au niveau d'un élargissement local (Le) est supérieure à l'espace (Ed) entre deux segments de doigt de collecte (2), la différence étant notamment supérieure à 200 microns et répartie de manière égale (Lc) de part et d'autre du bus (3) suivant la première direction (D1).

18. Procédé de fabrication selon l'une des revendications 15 à 17, **caractérisé en ce que** les première et deuxième étapes sont réalisées de sorte que la différence entre la largeur (Wd) du doigt de collecte (2) et la longueur (We) selon la deuxième direction (D2) suivant laquelle l'élargissement local (Le) de la largeur (Lb) du bus (3) est réalisé, est supérieure à 100 microns, cette différence étant notamment répartie de manière égale de part et d'autre du doigt de collecte (2) suivant la deuxième direction (D2).

19. Procédé de fabrication selon la revendication 13, **caractérisé en ce que** l'étape de métallisation comprend une première étape dans laquelle une première couche dudit au moins doigt de collecte (2) est réalisée sur le substrat (1) et une deuxième étape dans laquelle sont conjointement formés :
- ledit au moins un bus (3) sur le substrat (1) et à recouvrement d'une partie de la première couche de doigt de collecte (2) dans la zone de liaison électrique (4),
- une deuxième couche dudit au moins un doigt de collecte (2) sur sa première couche.

20. Procédé de fabrication selon la revendication 19, **caractérisé en ce que** la première étape est réalisée de sorte que la première couche de doigt de collecte (2) est discontinue au niveau de la zone de liaison électrique (4) audit au moins un bus (3), et présente au moins deux segments alignés selon la première direction (D1) avec interposition entre eux d'un espace (Ed) selon la première direction (D1).

21. Procédé de fabrication selon la revendication 20, **caractérisé en ce que** les première et deuxième étapes sont réalisées de sorte que la largeur totale (Lt) du bus (3) au niveau d'un élargissement local (Le) est supérieure à l'espace (Ed), la différence étant notamment supérieure à 100 microns et répartie de manière égale (Lc) de part et d'autre du bus (3) suivant la première direction (D1).

22. Procédé de fabrication selon l'une des revendications 19 à 21, **caractérisé en ce que** les première et deuxième étapes sont réalisées de sorte que le rapport entre la longueur (We) selon la deuxième direction (D2) suivant laquelle l'élargissement local (Le) de la largeur (Lb) du bus (3) est réalisé et la largeur (Wd) du doigt de collecte (2) correspondant selon la deuxième direction (D2), est supérieur à deux.

## Patentansprüche

1. Photovoltaikmodul, umfassend mehrere photovoltaische Zellen, jeweils umfassend mindestens einen Sammelfinger (2), der in eine erste Längsrichtung (D1) gerichtet ist, und mindestens eine Schiene (3), die in eine zweite Längsrichtung (D2) gerichtet ist, die einen Winkel mit der ersten Längsrichtung, insbesondere einen Winkel von 90 Grad, bildet, wobei die Schiene (3) im Bereich einer elektrischen Verbindungszone (4) zwischen der Schiene (3) und dem Sammelfinger (2) mindestens eine lokale Ausbreitung (Le) der Breite (Lb) der Schiene (3) in die erste Längsrichtung (D1) umfasst, wobei das Verhältnis zwischen der Länge (We) in die zweite Richtung (D2), in der die lokale Ausbreitung (Le) der Breite (Lb) der Schiene (3) hergestellt ist, und der Breite (Wd) des Sammelfingers (2) entsprechend der zweiten Richtung (D2) unbedingt größer als eins ist, wobei die photovoltaischen Zellen elektrisch miteinander mit Hilfe mindestens eines Metallbandes (5), das an mindestens eine Schiene (3) der photovoltaischen Zellen angeschlossen ist, verbunden sind, wobei das Modul **dadurch gekennzeichnet ist, dass** die Gesamtbreite (Lt) der Schiene (3) im Bereich einer lokalen Ausbreitung (Le) unbedingt größer als die Breite (Lr) des Metallbandes (5) in die erste Richtung (D1) ist, und dass die Breite (Lb) der Schiene (3) außerhalb der elektrischen Verbindungszone kleiner als die Breite (Lr) des Metallbandes (5) ist, mit einem Verhältnis zwischen der Breite (Lr) des Bandes (5) und der Breite (Lb) der Schiene (3), das größer als zwei, insbesondere größer als vier, ist.

2. Photovoltaikmodul nach Anspruch 1, **dadurch gekennzeichnet, dass** es eine Vielzahl von Sammelfingern (2) umfasst, und dass jeder Sammelfinger (2) der Vielzahl elektrisch mit der Schiene (3) in einer zugehörigen elektrischen Verbindungszone (4) verbunden ist, so dass die Schiene (3) den elektrischen Anschluss der Sammelfinger (2) untereinander und zwischen den elektrischen Verbindungszonen (4) herstellt.

3. Photovoltaikmodul nach Anspruch 2, **dadurch gekennzeichnet, dass** jede der elektrischen Verbindungszonen (4) zwischen der Schiene (3) und den Sammelfingern (2) eine lokale Ausbreitung (Le) der Breite (Lb) der Schiene (3) umfasst.

4. Photovoltaikmodul nach einem der Ansprüche 2 und 3, **dadurch gekennzeichnet, dass** die Gesamtbreite (Lt) der Schiene (3) im Bereich der lokalen Ausbreitung (Le) jeder elektrischen Verbindungszone (4) unbedingt größer als die Breite (Lb) der Schiene (3) außerhalb der elektrischen Verbindungszonen (4) ist.

5. Photovoltaikmodul nach Anspruch 4, **dadurch gekennzeichnet, dass** das Verhältnis zwischen der Breite (Lt) der Schiene (3) im Bereich einer lokalen Ausbreitung (Le) ihrer Breite und der Breite (Lb) der Schiene (3) außerhalb der elektrischen Verbindungszonen (4) größer als 1,25 ist.

6. Photovoltaikmodul nach einem der Ansprüche 4 und 5, **dadurch gekennzeichnet, dass** die Differenz zwischen der Breite (Lt) der Schiene (3) im Bereich einer lokalen Ausbreitung (Le) ihrer Breite und der Breite (Lb) der Schiene (3) außerhalb der elektrischen Verbindungszonen (4) größer als 400 Mikrometer ist.

7. Photovoltaikmodul nach einem der Ansprüche 2 bis 6, **dadurch gekennzeichnet, dass** eine gegebene Ausbreitung (Le) der Schiene (3) auf einer gegebenen Seite der Schiene (3) in die erste Richtung (D1) einem einzigen Sammelfinger (2) zugeordnet ist.

8. Photovoltaikmodul nach einem der Ansprüche 1 bis 7, **dadurch gekennzeichnet, dass** die Länge (We) in die zweite Richtung (D2), in die die lokale Ausbreitung (Le) der Breite (Lb) der Schiene (3) hergestellt ist, größer oder gleich 150 Mikrometer ist.

9. Photovoltaikmodul nach einem der Ansprüche 1 bis 8, **dadurch gekennzeichnet, dass** das Verhältnis zwischen der Länge (We) in die zweite Richtung (D2), in die die lokale Ausbreitung (Le) der Breite der Schiene (3) hergestellt ist, und der Breite (Wd) des entsprechenden Sammelfingers (2) in die zweite Richtung (D2) größer als zwei ist.

10. Photovoltaikmodul nach einem der Ansprüche 1 bis 9, **dadurch gekennzeichnet, dass** das Metallband (5), insbesondere aus Kupfer, mechanisch und elektrisch an mindestens eine Schiene (3) der photovoltaischen Zellen durch ein elektrisch leitendes Befestigungsmittel (6) vom Typ leitende Schweißnaht oder Haftverbindung auf der gesamten Länge der Schiene (3) oder einem Teil davon angeschlossen ist.

11. Photovoltaikmodul nach einem der Ansprüche 1 bis 10, **dadurch gekennzeichnet, dass** das Metallband (5) in die zweite Richtung (D2) auf der gesamten Länge eines Substrats (1), auf dem die Sammelfinger (2) und die mindestens eine Schiene (3) ausgebildet sind, und über das Substrat (1) hinaus ausgebildet ist, um den elektrischen Anschluss mehrerer photovoltaischer Zellen untereinander zu ermöglichen.

12. Photovoltaikmodul nach einem der Ansprüche 1 bis 11, **dadurch gekennzeichnet, dass** die Differenz zwischen der Gesamtbreite (Lt) der Schiene (3) im Bereich einer lokalen Ausbreitung (Le) und der Breite (Lr) des Metallbandes (5) größer als 400 Mikrometer ist.

13. Herstellungsverfahren eines Photovoltaikmoduls nach einem der Ansprüche 1 bis 12, umfassend einen Schritt der Metallisierung auf einem Substrat (1), der durchgeführt wird, um den mindestens einen Sammelfinger (2) und die mindestens eine Schiene (3) herzustellen, dann einen Schritt des Anschlusses des mindestens einen Metallbandes (5) an mindestens eine Schiene (3) der photovoltaischen Zellen.

14. Herstellungsverfahren nach Anspruch 13, **dadurch gekennzeichnet, dass** der Metallisierungsschritt in einem einzigen Schritt besteht, in dem der mindestens eine Sammelfinger (2) und die mindestens eine Schiene (3) gemeinsam ausgebildet werden.

15. Herstellungsverfahren nach Anspruch 13, **dadurch gekennzeichnet, dass** der Metallisierungsschritt einen ersten Schritt umfasst, in dem nur der mindestens eine Sammelfinger (2) auf dem Substrat (1) hergestellt wird, und einen zweiten Schritt, in dem nur die mindestens eine Schiene (3) auf dem Substrat (1) und mit Überlappung eines Teils des Sammelfingers (2) in der elektrischen Verbindungszone (4) hergestellt wird.

16. Herstellungsverfahren nach Anspruch 15, **dadurch gekennzeichnet, dass** der erste Schritt derart durchgeführt wird, dass der mindestens eine Sammelfinger (2) nicht durchgehend, im Bereich seiner elektrischen Verbindungszone (4) mit der mindestens einen Schiene (3) unterbrochen ist und mindestens zwei in die erste Richtung (D1) ausgerichtete Segmente aufweist, zwischen die ein Raum (Ed) in die erste Richtung (D1) zwischengefügt ist.

17. Herstellungsverfahren nach Anspruch 16, **dadurch gekennzeichnet, dass** der erste und der zweite Schritt derart durchgeführt werden, dass die Gesamtlänge (Lt) der Schiene (3) im Bereich einer lokalen Ausbreitung (Le) größer als der Raum (Ed) zwischen zwei Sammelfingersegmenten (2) ist, wobei die Differenz insbesondere größer als 200 Mikrometer und beiderseits der Schiene (3) in die erste Richtung (D1) gleich verteilt ist (Lc).

18. Herstellungsverfahren nach einem der Ansprüche 15 bis 17, **dadurch gekennzeichnet, dass** der erste und der zweite Schritt derart durchgeführt werden, dass die Differenz zwischen der Breite (Wd) des Sammelfingers (2) und der Länge (We) in die zweite Richtung (D2), in die die lokale Ausbreitung (Le) der Breite (Lb) der Schiene (3) hergestellt ist, größer als 100 Mikrometer ist, wobei diese Differenz insbesondere beiderseits des Sammelfingers (2) in die zweite Richtung (D2) gleich verteilt ist.

19. Herstellungsverfahren nach Anspruch 13, **dadurch gekennzeichnet, dass** der Metallisierungsschritt einen ersten Schritt umfasst, in dem eine erste Schicht des mindestens einen Sammelfingers (2) auf dem Substrat (1) hergestellt wird, und einen zweiten Schritt, in dem
- die mindestens eine Schiene (3) auf dem Substrat (1) und mit Überlappung eines Teils der ersten Sammelfingerschicht (2) in der elektrischen Verbindungszone (4),
- eine zweite Schicht des mindestens einen Sammelfingers (2) auf seiner ersten Schicht
gemeinsam gebildet werden.

20. Herstellungsverfahren nach Anspruch 19, **dadurch gekennzeichnet, dass** der erste Schritt derart durchgeführt wird, dass die erste Sammelfingerschicht (2) im Bereich der elektrischen Verbindungszone (4) mit der mindestens einen Schiene (3) nicht durchgehend ist und mindestens zwei Segmente aufweist, die in die erste Richtung (D1) ausgerichtet sind, wobei zwischen ihnen ein Raum (Ed) in die erste Richtung (D1) zwischengefügt ist.

21. Herstellungsverfahren nach Anspruch 20, **dadurch gekennzeichnet, dass** der erste und zweite Schritt derart durchgeführt werden, dass die Gesamtbreite (Lt) der Schiene (3) im Bereich einer lokalen Ausbreitung (Le) größer als der Raum (Ed) ist, wobei die Differenz insbesondere größer als 100 Mikrometer und beiderseits der Schiene (3) in die erste Richtung (D1) gleich verteilt ist (Lc).

22. Herstellungsverfahren nach einem der Ansprüche 19 bis 21, **dadurch gekennzeichnet, dass** der erste und zweite Schritt derart durchgeführt werden, dass das Verhältnis zwischen der Länge (We) in die zweite Richtung (D2), in die die lokale Ausbreitung (Le) der Breite (Lb) der Schiene (3) hergestellt ist, und der Breite (Wd) des entsprechenden Sammelfingers (2) in die zweite Richtung (D2) größer als zwei ist.

## Claims

1. Photovoltaic module comprising a plurality of photovoltaic cells, each cell comprising at least one collecting finger (2) oriented in a first elongation direction (D1) and at least one bus (3) oriented in a second elongation direction (D2) making an angle to the first elongation direction, especially an angle of 90 degrees, the bus (3) comprising, at a zone (4) of electrical connection between the bus (3) and the collecting finger (2), at least one local enlargement (Le) of the width (Lb) of the bus (3) along the first elongation direction (D1), the ratio of the length (We) in the second direction (D2) of the local enlargement (Le) of the width (Lb) of the bus (3) to the width (Wd) of the corresponding collecting finger (2) in the second direction (D2) being strictly higher than one, the photovoltaic cells being electrically connected to one another by way of at least one metal strip (5) interconnected with at least one bus (3) of the photovoltaic cells, the module being **characterised in that** the total width (Lt) of the bus (3) at a local enlargement (Le) is strictly larger than the width (Lr) of the metal strip (5) along the first direction (D1) and **in that** the width (Lb) of the bus (3) outside of the zone of electrical connection is smaller than the width (Lr) of the metal strip (5), with a ratio of the width (Lr) of the strip (5) to the width (Lb) of the bus (3) higher than two, especially higher than four.

2. Photovoltaic module according to Claim 1, **characterised in that** it comprises a plurality of collecting fingers (2) and **in that** each collecting finger (2) of said plurality is electrically connected to the bus (3) in an associated electrical connection zone (4), so that the bus (3) electrically connects the collecting fingers (2) to one another and between the electrical connection zones (4).

3. Photovoltaic module according to Claim 2, **characterised in that** each of the electrical connection zones (4) between the bus (3) and the collecting fingers (2) comprises a local enlargement (Le) of the width (Lb) of the bus (3).

4. Photovoltaic module according to either of Claims 2 and 3, **characterised in that** the total width (Lt) of the bus (3) at the local enlargement (Le) of any electrical connection zone (4) is strictly higher than the width (Lb) of the bus (3) outside of the electrical connection zones (4).

5. Photovoltaic module according to Claim 4, **characterised in that** the ratio of the width (Lt) of the bus (3) at a local enlargement (Le) of its width to the width (Lb) of the bus (3) outside of the electrical connection zones (4) is higher than 1.25.

6. Photovoltaic module according to either of Claims 4 and 5, **characterised in that** the difference between the width (Lt) of the bus (3) at a local enlargement (Le) of its width and the width (Lb) of the bus (3) outside of the electrical connection zones (4) is larger than 400 microns.

7. Photovoltaic module according to one of Claims 2 to 6, **characterised in that** a given enlargement (Le) of the bus (3) is associated, on a given side of the bus (3), along the first direction (D1), with a single collecting finger (2).

8. Photovoltaic module according to one of Claims 1 to 7, **characterised in that** the length (We) in the second direction (D2) of the local enlargement (Le) of the width (Lb) of the bus (3) is larger than or equal to 150 microns.

9. Photovoltaic module according to one of Claims 1 to 8, **characterised in that** the ratio of the length (We) in the second direction (D2) of the local enlargement (Le) of the width of the bus (3) to the width (Wd) of the corresponding collecting finger (2) in the second direction (D2) is higher than two.

10. Photovoltaic module according to one of Claims 1 to 9, **characterised in that** the metal strip (5), which is especially made of copper, is mechanically and electrically connected to at least one bus (3) of the photovoltaic cells, by an electrically conductive fastening means (6) such as a solder or a conductive adhesive, over all or some of the length of the bus (3).

11. Photovoltaic module according to one of Claims 1 to 10, **characterised in that** the metal strip (5) is oriented along the second direction (D2) over the entire length of a substrate (1) on which the collecting fingers (2) and said at least one bus (3) are formed, and beyond the substrate (1) in order to allow a plurality of photovoltaic cells to be electrically connected to one another.

12. Photovoltaic module according to one of Claims 1 to 11, **characterised in that** the difference between the total width (Lt) of the bus (3) at a local enlargement (Le) and the width (Lr) of the metal strip (5) is larger than 400 microns.

13. Manufacturing process of a photovoltaic module according to any one of Claims 1 to 12, comprising a step of metallising a substrate (1), carried out so as to form said at least one collecting finger (2) and said at least one bus (3), then a step of interconnecting said at least one metal strip (5) and at least one bus (3) of the photovoltaic cells.

14. Manufacturing process according to Claim 13, **characterised in that** the metallisation step consists of a single step in which said at least one collecting finger (2) and said at least one bus (3) are conjointly formed.

15. Manufacturing process according to Claim 13, **characterised in that** the metallisation step comprises a first step in which only said at least one collecting finger (2) is produced on the substrate (1), and a second step in which only said at least one bus (3) is produced on the substrate (1) and covering a portion of the collecting finger (2) in the electrical connection zone (4).

16. Manufacturing process according to Claim 15, **characterised in that** the first step is carried out so that said at least one collecting finger (2) is discontinuous, interrupted at its zone (4) of electrical connection to said at least one bus (3) and comprises at least two segments aligned in the first direction (D1) having interposed between them a space (Ed) in the first direction (D1).

17. Manufacturing process according to Claim 16, **characterised in that** the first and second steps are carried out so that the total width (Lt) of the bus (3) at a local enlargement (Le) is larger than the space (Ed) between two segments of collecting finger (2), the difference especially being larger than 200 microns and equally distributed (Lc) on either side of the bus (3) along the first direction (D1).

18. Manufacturing process according to one of Claims 15 to 17, **characterised in that** the first and second steps are carried out so that the difference between the width (Wd) of the collecting finger (2) and the length (We) in the second direction (D2) of the local enlargement (Le) of the width (Lb) of the bus (3) is larger than 100 microns, this difference especially being equally distributed on either side of the collecting finger (2) along the second direction (D2).

19. Manufacturing process according to Claim 13, **characterised in that** the metallisation step comprises a first step in which a first layer of said at least one collecting finger (2) is produced on the substrate (1), and a second step in which the following are conjointly formed:
- said at least one bus (3) on the substrate (1) and covering a portion of the first layer of the collecting finger (2) in the electrical connection zone (4); and
- a second layer of said at least one collecting finger (2) on its first layer.

20. Manufacturing process according to Claim 19, **characterised in that** the first step is carried out so that the first layer of the collecting finger (2) is discontinuous at the zone (4) of electrical connection to said at least one bus (3), and comprises at least two segments aligned in the first direction (D1) having interposed between them a space (Ed) in the first direction (D1).

21. Manufacturing process according to Claim 20, **characterised in that** the first and second steps are carried out so that the total width (Lt) of the bus (3) at a local enlargement (Le) is larger than the space (Ed), the difference especially being larger than 100 microns and equally distributed (Lc) on either side of the bus (3) along the first direction (D1).

22. Manufacturing process according to one of Claims 19 to 21, **characterised in that** the first and second steps are carried out so that the ratio of the length (We) in the second direction (D2) of the local enlargement (Le) of the width (Lb) of the bus (3) to the width (Wd) of the corresponding collecting finger (2) in the second direction (D2) is higher than two.
